# EUROPEAN PATENT SPECIFICATION

(11) **EP 2 190 044 B1**
(45) Date of publication and mention of the grant of the patent: **15.05.2013**
(21) Application number: 09014358.7
(22) Date of filing: 17.11.2009
(51) Int. Cl.: H01L 51/52, H01L 51/54, H01L 51/00

(54) **Light-emitting device, image display apparatus, and novel organic compound**
Lichtemittierende Vorrichtung, Bildanzeigevorrichtung und eine neuartige organische Verbindung
Dispositif électroluminescent, appareil d'affichage d'images, et nouveau composé organique

(30) Priority: 19.11.2008 JP 2008295802
(43) Date of publication of application: 26.05.2010
(73) Proprietor: Canon Kabushiki Kaisha, Tokyo (JP)
(72) Inventor: Kamatani, Jun, Ohta-ku Tokyo (JP); Yamada, Naoki, Ohta-ku Tokyo (JP); Saitoh, Akihito, Ohta-ku Tokyo (JP)
(74) Representative: Weser, Wolfgang

(56) References cited:
- EP-A1- 1 380 556
- WO-A1-2008/015945
- WO-A1-2008/078824

## Description

### BACKGROUND OF THE INVENTION

### Field of the Invention

The present invention relates to an organic light-emitting device and an image display apparatus. The invention also relates to a novel organic compound used therein.

### Description of the Related Art

An organic light-emitting device is a device in which a thin film including a fluorescent organic compound is sandwiched between an anode and a cathode, and electrons and holes are injected from the electrodes, thereby generating excitons in the fluorescent compound and using light emitted when the excitons return to the ground state.

An organic light-emitting device is sometimes also called an organic electroluminescence device or an organic EL device.

A significant progress attained in recent years in the field of organic light-emitting devices led to the development of thin and lightweight light-emitting devices that have a high luminance, a wide variety of emission wavelengths and high-speed responsiveness at a low applied voltage, thereby suggesting the possibility of wide-range applications.

Novel compounds have heretofore been intensively developed.

This is because the creation of a novel compound is important when it results in the development of a high-performance organic light-emitting device.

For example, Japanese Patent Laid-Open No. 10-189247, Japanese Patent Laid-Open No. 2005-235787, International Publication WO 2008-015945, and International Publication WO 2008-059713 describe examples using a 7,12-diphenyl[κ]benzofluoranthene skeleton in light-emitting devices.

From the standpoint of practical use, the organic compounds and organic light-emitting devices using the compounds that are described in the above-described patent documents still have room for improvement.

More specifically, light output with even higher luminance and high conversion efficiency are necessary for practical use. In addition, further improvements are necessary in terms of endurance, such as variation in performance with time in long-term use or deterioration caused by oxygen-containing atmosphere or moist air.

When applications to full-color displays are considered, the organic light-emitting devices sought for such applications are required to have good color purity and blue emission of high efficiency, but these problems are still to be resolved.

Therefore, an organic light-emitting device that demonstrates good color purity, light emission efficiency, and endurance and a material that makes it possible to realize such an organic light-emitting device are required.

### SUMMARY OF THE INVENTION

The invention has been created to resolve the above-described problems inherent to prior art. Thus, an aspect of the present invention provides a novel organic compound suitable for use in a blue light-emitting device and an organic light-emitting device having such a novel organic compound.

Accordingly, an aspect of the invention provides an organic light-emitting device having a cathode, an anode, and an organic compound layer disposed between the anode and the cathode as defined in claim 1.

Another aspect of the invention also provides

an organic compound as defined in claim 4.

The organic light-emitting device including the novel compound in accordance with aspects of the present invention can realize high-efficiency and high-luminance emission.

Further features of the present invention will become apparent from the following description of exemplary embodiments with reference to the attached drawings.

### BRIEF DESCRIPTION OF THE DRAWINGS

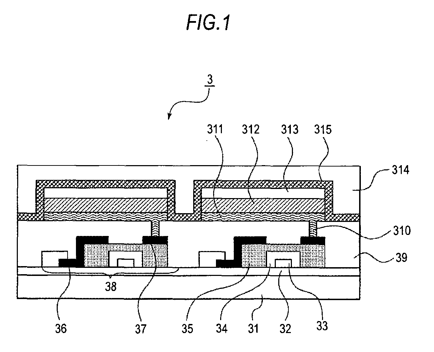

FIG. 1 is a cross-sectional schematic diagram illustrating an organic light-emitting device and a TFT located therebelow.

### DESCRIPTION OF THE EMBODIMENTS

The novel organic compound in accordance with aspects of the invention is an organic compound represented by General Formula (1) below.

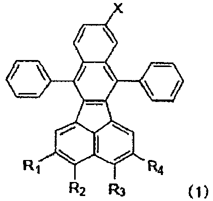

In General Formula (1),
X represents a substituted or unsubstituted fluoranthenyl group;
R₁ to R₄ independently represent a hydrogen atom, a substituted or unsubstituted alkyl group, a substituted or unsubstituted amino group, a substituted or unsubstituted aryl group, and a substituted or unsubstituted heterocyclic group.

More specifically, the novel organic compound of the invention as claimed is a compound represented by General Formula (2) below.

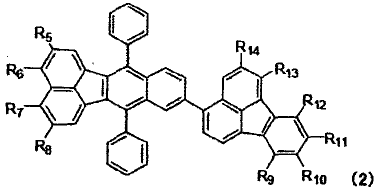

In General Formula (2),
R₅ to R₁₄ independently represent a hydrogen atom, a substituted or unsubstituted alkyl group, a substituted or unsubstituted amino group, a substituted or unsubstituted aryl group, and a substituted or unsubstituted heterocyclic group.

Examples of the substituted or unsubstituted alkyl group in General Formulas (1) and (2) include a methyl group, an ethyl group, a normal propyl group, an isopropyl group, a normal butyl group, a tertiary butyl group, a secondary butyl group, an octyl group, a 1-adamantyl group, and a 2-adamantyl group, but this list is particularly no limiting.

Examples of the substituted or unsubstituted amino group in General Formulas (1) and (2) include an N-methylamino group, an N-ethylamino group, an N,N-dimethylamino group, an N,N-diethylamino group, an N-methyl-N-ethylamino group, an N-benzylamino group, an N-methyl-N-benzylamino group, an N,N-dibenzylamino group, an anilino group, an N,N-phenylamino group, N,N-dinaphthylamino group, an N,N-difluorenylamino group, an N-phenyl-N-tolylamino group, an N,N-ditolylamino group, an N-methyl-N-phenylamino group, an N,N-dianisolylamino group, an N-mesityl-N-phenylamino group, an N,N-dimesitylamino group, an N-phenyl-N-(4-tertiary-butylphenyl)amino group, and N-phenyl-N-(4-trifluoromethylphenyl)amino group, but this list is particularly not limiting.

Examples of the substituted or unsubstituted aryl group in General Formulas (1) and (2) include a phenyl group, a naphthyl group, an indenyl group, a biphenyl group, a terphenyl group, and a fluorenyl group, but this list is particularly not limiting.

Examples of the substituted or unsubstituted heterocyclic group in General Formulas (1) and (2) include a pyridyl group, an oxazolyl group, an oxadiazolyl group, a thiazolyl group, a thiadiazolyl group, a carbazolyl group, an acrydinyl group, and a phenanthrolyl group, but this list is particularly not limiting.

Examples of the substituents in General Formulas (1) and (2), that is, substituents in the alkyl group, amino group, aryl group, and heterocyclic group, include an alkyl group such as a methyl group, an ethyl group, and a propyl group, an aralkyl group such as a benzyl group, an aryl group such as a phenyl group and a biphenyl group, a heterocyclic ring such as pyridyl group and pyrrolyl group, an amino group such as a dimethylamino group, a diethylamino group, a dibenzylamino group, a diphenylamino group, and a ditolylamino group, an alkoxyl group such as a methoxyl group, an ethoxyl group, a propoxyl group, and a phenoxyl group, a cyano group, and a halogen atom such as fluorine, chlorine, bromine, and iodine, but this list is particularly not limiting.

Specific examples of the compound represented by General Formula (1) above are shown below. Compounds A1-A19 and C1-C20 are not part of the invention.

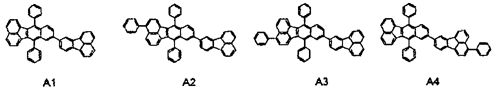

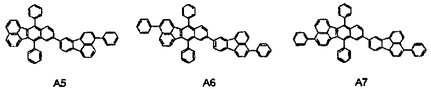

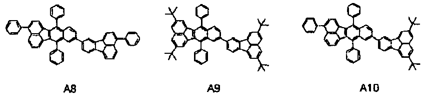

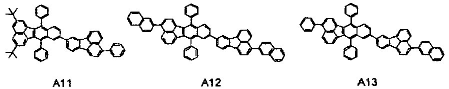

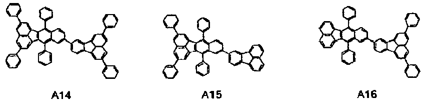

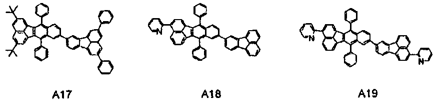

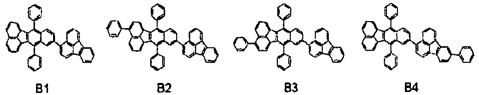

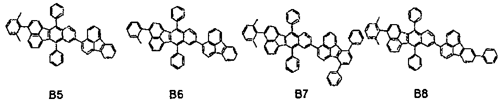

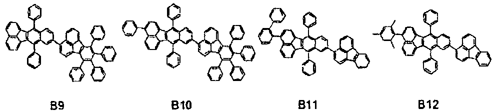

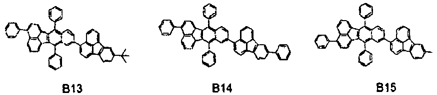

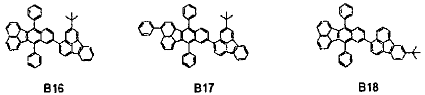

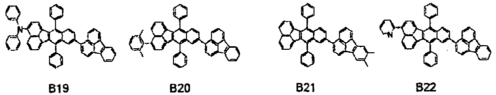

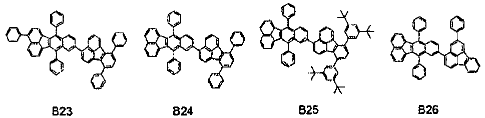

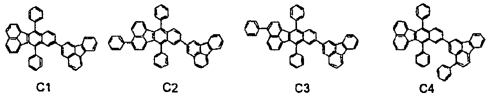

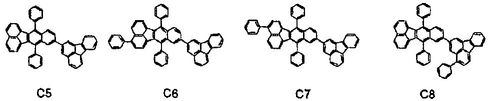

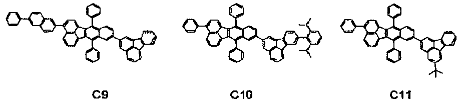

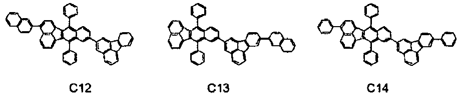

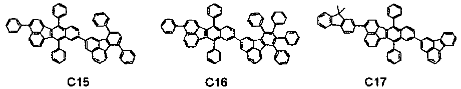

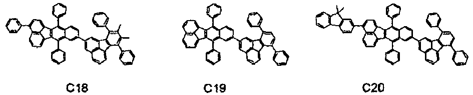

The novel organic compound in accordance with aspects of the present invention will be described below in greater detail.

Typically, in order to increase the emission efficiency of an organic light-emitting device, it is desirable that the emission quantum yield of the emission center material itself be high.

The research results obtained by the inventors demonstrated that the organic compound represented by General Formula (1) has a high quantum efficiency in a diluted solution. Therefore, it can be said that when the organic compound represented by General Formula (1) is used in an organic light-emitting device, a high emission efficiency can be expected.

The organic compound in accordance with aspects of the present invention has a fluoranthenyl group in 9 position of a 7,12-diphenyl[K]benzofluoranthene skeleton.

The organic light-emitting device of an organic EL display is required to have blue emission. A physical property required for a material suitable for blue emission in an organic light-emitting device is that the emission peak of the light-emitting material be within a range of equal to or greater than 430 nm and equal to or less than 480 nm.

It is also preferred that the organic compound for use in an organic light-emitting device be a material with a molecular weight of equal to or less than 1000.

This is because the purification conducted by using sublimation purification demonstrates strong effect in increasing the level of purity of organic compounds. The sublimation purification is preferably conducted at a stage immediately before the organic compound is used, that is, as a final purification process.

Good thermal stability is also desirable for organic compounds. The organic compound in accordance with aspects of the present invention is in this sense also advantageous. This is because when the sublimation purification or vapor deposition is used, a temperature of equal to or higher than 300 degrees acts upon the organic compound under a high vacuum of about 10⁻³ Pa. In this case, where an organic compound has low thermal stability, the compound is decomposed or participates in a reaction and the desirable physical properties cannot be obtained.

For example, let us assume that a substituent having a peri position is introduced in a 3 position of fluoranthene or [κ]benzofluoranthene in an organic compound having a fluoranthene or [κ]benzofluoranthene skeleton. In this case, a 4 position of fluoranthene or [κ]benzofluoranthene has a much higher reactivity than that in the case of usual naphthalene, and a cyclization reaction is easily induced by heat.

More specifically, the reaction represented by the following formula occurs.

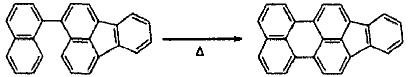

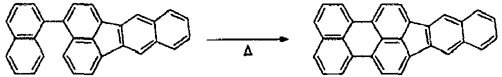

Where such cyclization reaction starts, the compound absorption and emission wavelength becomes larger. The resultant problem is that the emission of the original compound in which emission occurs at a wavelength different from that of the original compound is absorbed by the cyclicized compound and the emission intensity decreases.

The inventors have found out that this is very important in terms of molecular design when the fluoranthene or [κ]benzofluoranthene skeleton is used as the light-emitting device.

The organic compound in accordance with aspects of the present invention has both the [κ]benzofluoranthene skeleton and the fluoranthene skeleton (fluoranthenyl group), and the fluoranthenyl group is introduced in a 9 position of [κ]benzofluoranthene.

As a result, the compound emits blue light and has no site that is cyclized by heat. Therefore, chemical changes induced by sublimation purification, vapor deposition, of heat during operation can be inhibited.

Further, [κ]benzofluoranthene has high planarity and easily generates excimers if not substituted.

In the organic compound in accordance with aspects of the present invention, phenyl groups are introduced in positions close to the center of the benzofluoranthene skeleton, that is, a 7 position and a 12 position. As a result, these phenyl groups are almost orthogonal to [κ]benzofluoranthene and can inhibit the formation of excimers. The orthogonally as referred to herein means a mutual arrangement in which planes of phenyl groups are orthogonal to the plane of benzofluoranthene.

An additional result is that the phenyl groups produce little effect on the emission wavelength of [κ]benzofluoranthene.

The position of the fluoranthenyl group that is bonded to the 9 position of [κ]benzofluoranthene is not particularly limited, but a 3 position of the fluoranthenyl group is more preferred. This is because when the compound is used as a light-emitting material, concentration extinction occurs that is caused by stacking of molecules, whereas in a case of bonding at the 3 position of the fluoranthenyl group, a structure is obtained in which it is sterically most difficult to be in plane with the [κ]benzofluoranthene. As a result, stacking of molecules can be inhibited and concentration extinction can be inhibited.

As for the emission wavelength of the organic compound, because [κ]benzofluoranthene and fluoranthene skeleton are in one molecule, an emission wavelength can be obtained within a range of equal to or greater than 430 nm and equal to or less than 440 nm.

In order to use the organic compound in accordance with aspects of the present invention advantageously as a blue light-emitting material, a substituent is further introduced into a molecule constituted by [κ]benzofluoranthene and fluoranthene skeleton. It means tuning of emission wavelength.

The blue region is within a range of equal to or greater than 430 nm and equal to or less than 480 nm, and by introducing the substituent into the organic compound in accordance with aspects of the present invention, it is possible to obtain light emission with a wavelength of equal to or greater than 440 nm and equal to or less than about 480 nm.

The position for introducing the substituent is not particularly limited.

More specifically, a position for introducing the substituent is preferably from a 2 position to a 5 position of [κ]benzofluoranthene. It is even more preferred that the substituent be introduced in a 3 position or a 4 position that are positioned with high reactivity. Introducing the substituent into these positions is preferred because the emission wavelength of the organic compound can be enlarged. Further, introducing an alkyl group as the substituent is preferred because of inhibition effect demonstrated with respect to the concentration extinction caused by stacking of organic compounds.

9-Bromo-7,12-diphenyl[κ]benzofluoranthene that is a starting material for the organic compound represented by General Formula [1] can be synthesized by a Synthesis Route 1 or 2 indicated below with reference to Journal of Organic Chemistry (1952), 17, 845-54 or Journal of the American Chemical Society (1952).

The organic compound represented by General Formula [1] can be obtained by cross coupling this starting material and fluoranthene. Because various substituents are introduced, the synthesis can be conducted by substituting the hydrogen atom, for example, with other substituents such as an alkyl group, a halogen atom, and a phenyl group.

### Synthesis Route 1

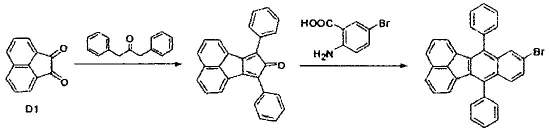

### Synthesis Route 2

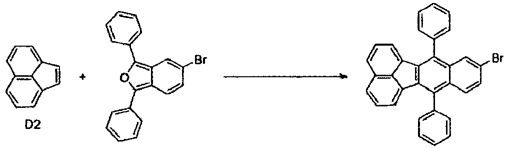

Various organic compounds in accordance with aspects of the present invention can be synthesized from the starting material D1 or D2 and the fluoranthene starting material. These organic compounds that can be synthesized are presented in the following table (synthetic compound in Table 1 below). The starting materials (starting material D1 or D2) and fluoranthene starting materials are also presented in the table.

**Table 1**

| | Staring material D1 or D2 | Fluoranthene starting material | Synthetic compound |
|---|---|---|---|
| Synthesis Example 1 | 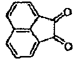 | 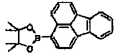 | 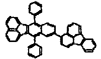 |
| Synthesis Example 2 | 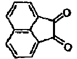 | 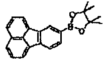 | 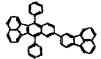 |
| Synthesis Example 3 | 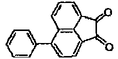 | 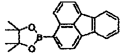 | 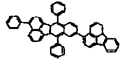 |
| Synthesis Example 4 | 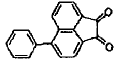 | 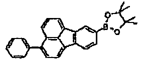 | 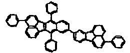 |
| Synthesis Example 5 | 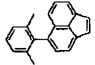 | 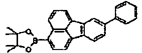 | 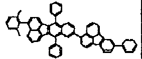 |
| Synthesis Example 6 | 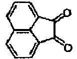 | 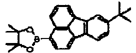 | 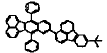 |
| Synthesis Example 7 | 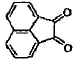 | 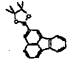 | 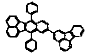 |
| Synthesis Example 8 | 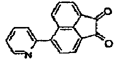 | 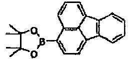 | 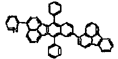 |

The organic light-emitting device in accordance with aspects of the invention will be described below.

The organic light-emitting device in accordance with aspects of the invention has at least an anode and a cathode, which are a pair of electrodes, and an organic compound layer disposed between the electrodes.

The organic compound layer has an organic compound represented by General Formula (1) or (2) above. The organic light-emitting device is a device in which light is emitted by a light-emitting material that is the organic compound disposed between the pair of electrodes.

In a case where one layer from among the organic compound layers is the light-emitting layer, the light-emitting layer may be constituted only by the organic compound in accordance with aspects of the present invention or the organic compound in accordance with aspects of the present invention may be contained as part thereof.

In a case where only part of the light-emitting layer may be constituted by the organic compound in accordance with aspects of the present invention, the organic compound in accordance with aspects of the present invention may be the main component of the light-emitting layer, or may be a secondary component.

The main component and secondary component as referred to herein are such that a component with a larger weight or molar ratio in the entire compound constituting the light-emitting layer is called the main component, and the component with a smaller ratio is called the secondary component.

The material that is the main component can be also called a host material.

The material that is the secondary component can be also called a dopant (guest) material, an emission assist material, and an electron injection material.

In a case where the organic compound in accordance with aspects of the present invention is used as the guest material, the concentration of the guest material in the host material is preferably equal to or greater than 0.01 wt.% and equal to or less than 20 wt.%, more preferably equal to or greater than 0.5 wt.% and equal to or less than 10 wt.%. Further, by changing the concentration of the guest material within any of the above-described two ranges, it is possible to increase the wavelength of light emitted from the light-emitting layer over that of the solution within a range of equal to or greater than 5 nm and equal to or less than 20 nm.

In a case where the light-emitting layer is composed of a guest material and host material with carrier transport ability, the main processes involved in emission include the following several processes.

1. Transport of electrons and holes in the light-emitting layer.

2. Generation of excitons in the host material.

3. Transmission of excitation energy between molecules of the host material.

4. Transfer of excitation energy from the host material to the guest material.

The desired energy transfer or light emission in each process competes with various deactivation processes.

It goes without saying that a large quantum yield of emission of the light-emitting center material (for example, guest material) is important for increasing emission efficiency of organic light-emitting devices. However, how to conduct efficiently the transfer of energy between the host material and the host material or between the host material and the guest material becomes a major problem. Although the causes of emission deterioration due to conduction are presently not clear, it can be assumed that the emission deterioration is associated at least with the emission center material itself or changes in the environment of the light-emitting center material caused by peripheral molecules thereof.

The comprehensive research conducted by the inventors demonstrated that a device using the compound represented by General Formula (1) in accordance with aspects of the invention as the host material or guest material of the light-emitting layer, in particular the guest material, has high-efficiency and high-luminance light output and excellent endurance.

The organic light-emitting device in accordance with aspects of the present invention will be described below in greater detail.

The organic light-emitting device in accordance with aspects of the present invention is composed at least of a pair of electrodes including an anode and a cathode and an organic compound layer sandwiched between the pair of electrodes. The organic compound layer includes at least one kind of the organic compound represented by General Formula (1).

A compound layer other than the organic compound layer may be contained between the pair of electrodes.

Two or more compound layers including the organic compound layer may be provided between the pair of electrodes. The device of such a configuration is called a multilayer organic light-emitting device.

The first to fifth preferred examples of multilayer organic light-emitting device will be described below.

A multilayer organic light-emitting device of the first example has a configuration in which an anode, a light-emitting layer, and a cathode are successively provided on a substrate. Such a configuration is useful in a case where the organic light-emitting device itself has hole transport ability, electron transport ability, and light-emitting ability, or compounds having the respective characteristic are mixed together.

A multilayer organic light-emitting device of the second example has a configuration in which an anode, a hole transport layer, an electrode transport layer, and a cathode are successively provided on a substrate. Such a configuration is useful in a case where a material having either the hole transport ability or the electron transport ability, or both functions is used as a light-emitting substance is each layer and a simple hole transport substance or electron transport substance that has no light emitting ability is used in combination with such material. In this case, the light-emitting layer is composed of either the hole transport layer or the electron transport layer.

A multilayer organic light-emitting device of the third example has a configuration in which an anode, a hole transport layer, a light-emitting layer, an electron transport layer, and a cathode are successively provided on a substrate. In this device, the carrier transport function and light emission function are separated. Further, compounds having hole transport ability, electron transport ability, and light emitting ability can be appropriately combined together. In this case, the degree of freedom in material selection is greatly increased and various compounds of different emission wavelength can be used. Therefore, the variety of emission hues can be increased. In addition, carriers or excitons can be effectively confined in the central light-emitting layer and emission efficiency can be increased.

A multilayer organic light-emitting device of the fourth example has a configuration in which an anode, a hole injection layer, a hole transport layer, a light-emitting layer, an electron transport layer, and a cathode are successively provided on a substrate. Such a configuration effectively improves adhesion of the anode and hole transport layer or improves the hole injection ability and also effectively reduced voltage.

A multilayer organic light-emitting device of the fifth example has a configuration in which an anode, a hole transport layer, a light-emitting layer, a hole-exciton blocking layer, an electron transport layer, and a cathode are successively provided on a substrate. In this configuration, a layer (hole-exciton blocking layer) that prevents holes and excitons from moving to the cathode side is inserted between the light-emitting layer and electron transport layer. Such a configuration effectively increases light emission efficiency by using a compound with a very high ionization potential as a hole-exciton blocking layer.

The light-emitting region that includes the compound represented by General Formula (1) in accordance with aspects of the invention is the region of the above-described light-emitting layer.

The first to fifth examples of the multilayer configurations are very basic device configurations, and the configuration of the organic light-emitting device using the compound in accordance with aspects of the present invention is not limited thereto. Thus, various layered configurations are possible, for example, an insulating layer can be provided at the interface of an electrode and an organic layer, an adhesive layer or an interference layer may be provided, and an electron transport layer or a hole transport layer may be composed of two layers having different ionization potentials.

The compound represented by General Formula (1) in accordance with aspects of the invention can be used in any of the configurations of the first to fifth examples.

In the light-emitting device in accordance with aspects of the invention, at least one kind of organic compound represented by General Formula (1) that is used in accordance with aspects of the invention is contained in the layer including the organic compound, and it is especially preferred that the compound be used as the guest material of the light-emitting layer.

The organic compound in accordance with aspects of the invention may be also used as the host material of the light-emitting layer.

The organic compound in accordance with aspects of the invention may be used in layers other than the light-emitting layer, that is, in any of the hole injection layer, hole transport layer, hole-exciton blocking layer, and electron transport layer, or in the electron injection layer.

If necessary, the conventional well-known low-molecular and high-molecular hole transporting compounds, light-emitting compounds, and electron transporting compounds can be used in addition to the organic compound in accordance with aspects of the invention.

Examples of these other compounds are presented below.

A material with high hole mobility into which holes can be easily injected from the anode and which can transport the injected holes into the light-emitting layer is preferred as the hole injecting and transporting material. Examples of low-molecular and high-molecular materials having hole injecting and transporting ability include triarylamine derivatives, phenylenediamine derivatives, stilbene derivatives, phthalocyanine derivatives, porphyrin derivatives, poly(vinyl carbazole), poly(thiophene), and other electrically conductive polymers, but this list is particularly not limiting.

Examples of suitable host materials include the compounds shown in Table 2, compounds that are derivatives of the compounds shown in Table 2, and also condensed ring compounds (for example, fluorene derivatives, naphthalene derivatives, anthracene derivatives, pyrene derivatives, carbazole derivatives, quinoxaline derivatives, and quinoline derivatives), organic aluminum complexes such as tris(8-quinolinolato)aluminum, organic zinc complexes, triphenylamine derivatives, poly(fluorene) derivatives, and poly(phenylene) derivatives, but this list is obviously not limiting.

**Table 2**

| | | | |
|---|---|---|---|
| H1 | H2 | H3 | H4 |
| 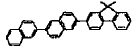 | 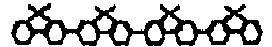 | 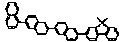 | 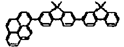 |
| H5 | H6 | H7 | H8 |
| 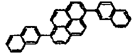 | 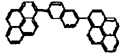 | 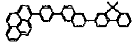 | 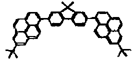 |
| H9 | H10 | H11 | H12 |
| 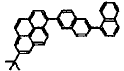 | 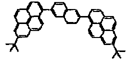 | 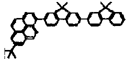 | 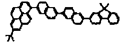 |
| H13 | H14 | H15 | H16 |
| 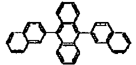 | 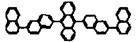 | 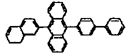 | 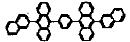 |
| H17 | H18 | H19 | H20 |
| 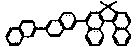 | 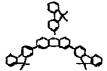 | 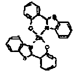 | 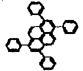 |

Any material into which electrons can be easily injected from the cathode and which can transport the injected electrons into the light-emitting layer can be selected as the electron injecting and transporting material, and the appropriate material is selected with consideration for balance with the hole mobility of the hole injecting and transporting layer. Examples of the material having electron injecting and transporting ability include oxadiazole derivatives, oxazole derivatives, pyrazine derivatives, triazole derivatives, triazine derivatives, quinoline derivatives, quinoxaline derivatives, phenanthroline derivatives, and organic aluminum complexes, but this list is particularly not limiting.

A material with as high a work function as possible is preferred as an anode material. Examples of such materials include metals such as gold, platinum, silver, copper, nickel, palladium, cobalt, selenium, vanadium, and tungsten, alloys therefor, and metal oxides such as tin oxide, zinc oxide, indium oxide, indium tin oxide (ITO), and indium zinc oxide. Further, electrically conductive polymers such as polyaniline, polypyrrole, and polythiophene can be also used. These electrode substances may be used individually or in combinations of a plurality thereof. Further, the anode may have a single-layer configuration or a multilayer configuration.

By contrast, a material with as low a work function as possible is preferred as the cathode material. Examples of suitable materials include alkali metals such as lithium, alkaline earth metals such as calcium, metals such as aluminum, titanium, manganese, silver, lead, and chromium. Alloys including combinations of these metals can be also used. For example, a magnesium - silver alloy, an aluminum - lithium alloy, and an aluminum - magnesium alloy can be used. Metal oxides such as indium tin oxide (ITO) can be also used. These electrode substances may be used individually or in combinations of a plurality thereof. Further, the cathode may have a single-layer configuration or a multilayer configuration.

The substrate suitable for the organic light-emitting device in accordance with aspects of the present invention is not particularly limited, and a non-transparent substrate such as a metal substrate and a ceramic substrate or a transparent substrate such as glass, quartz, and a plastic sheet can be used. Further, the emitted color light can be controlled by using a color filter film, a fluorescent color conversion filter film, and a dielectric reflective film for the substrate.

A protective layer or a sealing layer can be provided at the produced device with the object of preventing the device from contact with oxygen or moisture. Examples of suitable protective layers include inorganic material films such as a thin diamond film, a metal oxide, or a metal nitride, a polymer film such as a fluororesin, polyethylene, silicone resin, and a polystyrene resin, and a photocurable resin. Furthermore, the device can be covered with glass, gas-impermeable film, or metal, and the device itself can be packaged with an appropriate sealing resin.

In the organic light-emitting device in accordance with aspects of the invention, the layer including the organic compound in accordance with aspects of the invention, and layers composed of other organic compounds can be formed by the following methods. Thin films are typically formed by vacuum vapor deposition, ionization-assisted vapor deposition, sputtering, plasma, or a well-known coating method using dissolution in an appropriate solvent (for example, spin coating, dipping, casting, LB method, and an ink jet method). Where the layers are formed by a vacuum vapor deposition method or solution coating method, crystallization hardly occurs and excellent long-term stability is attained. Further, where the film is formed by a coating method, it is possible to form a film by using a combination with an appropriate binder resin.

Examples of the binder resin include a polyvinyl carbazole resin, a polycarbonate resin, a polyester resin, an ABS resin, an acrylic resin, a polyimide resin, a phenolic resin, an epoxy resin, a silicone resin, and a urea resin, but this list is not limiting. These binder resins can be used individually in the form of homopolymers or copolymers or can be used in mixtures of two or more thereof. If necessary, they can be used together with a well-known additive such as a plasticizer, an antioxidant, and an ultraviolet absorber.

The organic light-emitting device in accordance with aspects of the present invention can be applied to products that require reduced energy consumption or high luminance. Examples of applications include light sources of display apparatus, illumination apparatus, and printers and backlight of liquid crystal display apparatus.

Flat panel displays, which feature low energy consumption, high visibility, and small weight, can be used as the display apparatus. The display apparatus can be used as image display apparatus, for example, for PC, TV sets, or advertizing medium. Alternatively, the display apparatus may be used for display units of image pickup apparatus such as digital still cameras and digital video cameras.

Further, the display apparatus may be also used in image forming apparatus of an electrophotographic system, that is, in operation display units of laser beam printers or copiers.

Applications are also possible as light sources for exposing latent images on a photosensitive medium in image forming apparatus of an electrophotographic system, that is, laser beam printers and copiers. A latent image can be formed by disposing a plurality of organic light-emitting devices that can be independently addressed in an arrays (for example, lines) and conducting the desired exposure on the photosensitive drum. By using the organic light-emitting device in accordance with aspects of the invention, it is possible to reduce space that has been considered necessary for disposing a light source, a polygon mirror, and various optical lenses.

The invention can be expected to reduce energy consumption in illumination apparatus and backlight. The organic light-emitting device in accordance with aspects of the invention can be also used as a planar light source.

Further, the emission color can be controlled by providing a color filter film, a fluorescent color conversion filter film, and a dielectric reflection film on a substrate that supports the organic light-emitting device in accordance with aspects of the present invention. Further, the emission mode - non-emission mode can be controlled by providing a thin-film transistor (TFT) on a substrate and connecting the organic light-emitting device thereto. Either of the source electrode and drain electrode of the TFT is connected to either of the anode and cathode of the organic light-emitting device. A plurality of the organic light-emitting devices can be disposed as a matrix, that is, in the in-plane direction, and used as an illumination apparatus.

A display apparatus using the organic light-emitting device in accordance with aspects of the invention will be explained below. This display apparatus has organic light-emitting devices in accordance with aspects of the present invention and TFT that control the emission luminance of the organic light-emitting devices. If necessary, a means can be provided for supplying electric signals to the organic light-emitting device in accordance with aspects of the present invention. By controlling the organic light-emitting devices with TFT, it is possible to provide a display apparatus of an active matrix system.

FIG. 1 is a cross-sectional schematic view of the display apparatus having organic light-emitting devices in pixel sections. This figure shows two organic light-emitting devices and two TFT. One organic light-emitting device is connected to one TFT.

In the figure, the reference numeral 3 represents a display apparatus, 38 - a TFT device, 31 - a substrate, 32 - a moistureproof film, 33 - a gate electrode, 34 - a gate insulating film, 35 - a semiconductor layer, 36 - a drain electrode, 37 - a source electrode, 39 - an insulating film, 310 - a contact hole, 311 - an anode, 312 - an organic layer, 313 - a cathode, 314 - a first protective layer, and 315 - a second protective layer.

In the display apparatus 3, the moistureproof film 32 for protecting components (TFT or organic layer) produced on the substrate 31 made from glass or the like is provided on the substrate. Silicon oxide or a composite of silicon oxide and silicon nitride can be used as a material constituting the moistureproof film 32. The gate electrode 33 is provided on the moistureproof film 32. The gate electrode 33 can be obtained by forming a film of a metal such as Cr by sputtering.

The gate insulating film 34 is disposed so as to cover the gate electrode 33. The gate insulating film 34 is produced from silicon oxide by a plasma CVD method or catalytic chemical vapor deposition method (cat-CVD method) and patterned. The semiconductor layer 35 is provided so as to cover the gate insulating film 34 that has been patterned and provided for each region that will serve for TFT. The semiconductor layer 35 is obtained by forming a silicon film by a plasma CVD method or the like (in some cases, annealing can be performed at a temperature of equal to or higher than 290°C) and then patterning according to the circuit shape.

The drain electrode 36 and source electrode 37 are provided at each semiconductor layer 35. Thus, the TFT device 38 has the gate electrode, gate insulating film, semiconductor layer, drain electrode, and source electrode. The insulating film 39 is provided on top of the TFT device 38. Then, the contact hole (through hole) 310 is provided in the insulating film 39, and the metallic anode 311 and source electrode 37 for the organic light-emitting device are connected.

The multilayer or single-layer organic layer 312 and cathode 313 are then successively laminated on the anode 311 to configure an organic light-emitting device.

In the present embodiment, the first protective layer 314 and second protective layer 315 may be provided to prevent the organic light-emitting device from deterioration.

The above-described display apparatus is not limited to switching devices and can be readily applied not only to the above-described TFT, but also a monocrystalline silicon substrate, a MIM device, and an a-Si configuration.

An organic light-emitting display panel can be obtained by successively laminating a multilayer or single-layer organic light-emitting layer - cathode layer on the ITO electrode. By driving the display panel using the organic compound in accordance with aspects of the present invention, it is possible to obtain good image quality and stable display over a long time.

As for the light take-out direction, both the bottom emission configuration (configuration in which the light is taken out from the substrate side) and the top emission configuration (configuration in which the light is taken out from the side opposite that of the substrate) can be used.

### EXAMPLES

The invention will be explained below in greater detail by examples thereof, but the invention is not limited to these examples.

<Example 1>

### [Synthesis of Example Compound B1]

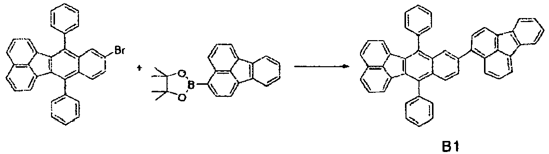

A total of 966 mg (2 mmole) of 9-bromo-7,12-diphenyl[κ]benzofluoranthene, 656 mg (2 mmole) of 2-(fluoranthene-3-yl)-4,4,5,5-tetramethyl-1,3,2-dioxaborane, 0.05 g of Pd(PPh₃)₄, 20 ml of toluene, 10 ml of ethanol, and 20 ml of 2M aqueous solution of sodium carbonate were placed into a round bottom flask with a capacity of 100 ml and stirred for 8 h at a temperature of 80°C under a nitrogen gas flow. Upon completion of the reaction, the crystals were filtered and washed with water, ethanol, and heptane. The crystals obtained were heated and dissolved in toluene, thermal-time filtered, and recrystallized in toluene/heptane. The crystals were vacuum dried at 120°C and then sublimation purified, thereby producing 870 mg (yield 72%) of Example Compound B1 in the form of light-yellow crystals.

The structure of this compound was confirmed by NMR measurements.

¹H NMR (CDCl₃, 500 MHz), σ (ppm): 7.93-7.91 (m, 5H), 7.87 (s, 1H), 7.79 (d, 1H, J = 6.8 Hz), 7.73-7.57 (m, 15H), 7.38-7.32 (m, 4H), 6.68-6.64 (m, 2H)

An emission spectrum of a toluene solution of the Example Compound B1 with a concentration of 1 × 10⁻⁵ mol/l was found by measuring photoluminescence at an excitation wavelength of 350 nm by using Hitachi F-4500. A spectrum having a maximum intensity at 438 nm was obtained.

### <Comparative Example 1>

Thermal stability was compared using Compound E1 as a comparative example.

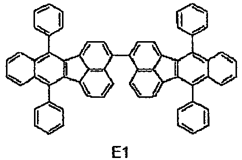

The material B1 that was used in the light-emitting device in accordance with aspect of the invention and the material E1 as a comparative example were heated to a temperature of 360°C under a vacuum of 2.0 × 10⁻¹ Pa. The material E1 gradually changed its color to red and an emission peak derived from E2 could be confirmed. The material B1 melted and yellowed, but no novel compound could be confirmed by analysis after cooling.

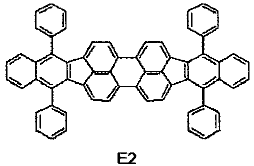

### <Examples 2 to 10>

In these examples, devices of the fifth example (anode - hole injection layer - hole transport layer - light-emitting layer - hole exciton blocking layer - electron transport layer - cathode) of the multilayer organic light-emitting device were obtained. ITO with a thickness of 100 nm was patterned on a glass substrate. The below-described organic layer and electrode layers were continuously formed on the ITO substrate by vacuum vapor deposition using resistance heating in a vacuum chamber at 10⁻⁵ Pa, so that the opposite electrode areas were 3 mm².
Hole transport layer (30 nm): F-1.
Light-emitting layer (30 nm): host F-2, guest: example compound (weight ratio 5%).
Hole-exciton blocking layer (10 nm): F-3.
Electron transport layer (30 nm): F-4.
Metallic electrode layer 1 (1 nm): LiF.
Metallic electrode layer 2 (100 nm): Al.

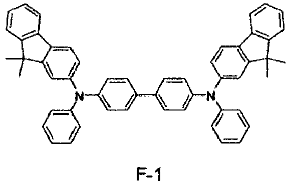

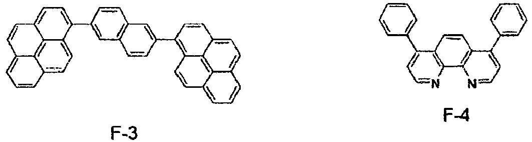

As for the properties of the EL device, a current-voltage characteristic was measured with a microammeter 4140B produced by Hewlett Packard Co., and the emission luminance was measured with BM7 produced by Topcon Co.

The emission efficiency and voltage obtained in Example 2 to Example 10 are shown in Table 3.

**Table 3**

| | Guest | F-2 | Emission efficiency (cd/A) | Voltage (V) |
|---|---|---|---|---|
| Example 2^{a} | A1 | H7 | 3.5 | 3.9 |
| Example 3 | B1 | H11 | 4.2 | 3.8 |
| Example 4 | B1 | H12 | 4.3 | 3.8 |
| Example 5 | B2 | H12 | 4.7 | 3.8 |
| Example 6 | B2 | H16 | 4.5 | 4.1 |
| Example 7 | B5 | H5 | 4.5 | 3.9 |
| Example 8 | B22 | H4 | 3.9 | 3.8 |
| Example 9^{a} | C1 | H13 | 3.5 | 4.2 |
| Example 10^{a} | C12 | H18 | 3.5 | 4.1 |

| | | | | |
|---|---|---|---|---|
| ^{a} Not forming part of the invention | | | | |

### Results and Discussion

Because the organic compound in accordance with aspects of the present invention has a fluoranthenyl group in a 9 position of [κ]benzofluoranthene, vapor deposition can be conducted without causing heat-induced chemical reactions, as in an organic compound in which a 3 position of fluoranthene is bonded to a 3 position of[K]benzofluoranthene. Further, a compound having suitably blue emission can be produced. By using this material for a light-emitting device, it is possible to obtain good emission characteristics.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An organic light-emitting device having a cathode, an anode, and an organic compound layer disposed between the anode and the cathode, **characterized in that** the organic compound layer includes an organic compound represented by General Formula (2): 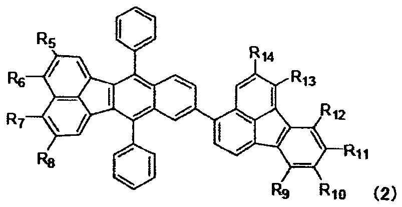 wherein R₅ to R₁₄ independently represent a hydrogen atom, a substituted or unsubstituted alkyl group, a substituted or unsubstituted amino group, a substituted or unsubstituted aryl group, and a substituted or unsubstituted heterocyclic group.

2. The organic light-emitting device according to claim 1, wherein the organic compound layer is a light-emitting layer.

3. An image display apparatus that has a plurality of pixels, wherein the pixels are the organic light-emitting devices according to claim 1, and also means for supplying electric signals to the organic light-emitting devices.

4. An organic compound represented by General Formula (2): 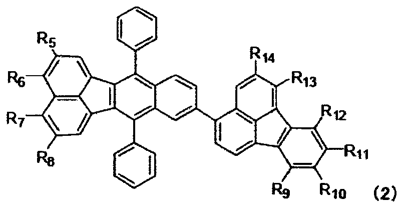 wherein R₅ to R₁₄ independently represent a hydrogen atom, a substituted or unsubstituted alkyl group, a substituted or unsubstituted amino group, a substituted or unsubstituted aryl group, and a substituted or unsubstituted heterocyclic group.

## Patentansprüche

1. Organische lichtemittierende Vorrichtung mit einer Kathode, einer Anode und einer zwischen Anode und Kathode angeordneten Schicht mit einer organischen Verbindung,
**dadurch gekennzeichnet, dass**
die Schicht mit einer organischen Verbindung eine durch die nachstehende allgemeine Formel (2) angegebene organische Verbindung aufweist: 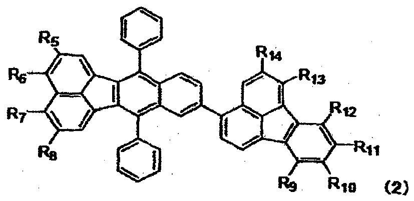 worin R₅ bis R₁₄ unabhängig voneinander bedeuten
- ein Wasserstoffatom,
- eine substituierte oder unsubstituierte Alkylgruppe,
- eine substituierte oder unsubstituierte Aminogruppe,
- eine substituierte oder unsubstituierte Arylgruppe und
- eine substituierte oder unsubstituierte heterocyclische Gruppe.

2. Vorrichtung nach Anspruch 1, wobei
die Schicht mit einer organischen Verbindung eine lichtemittierende Schicht ist.

3. Bildanzeigevorrichtung, mit mehreren Pixeln, die vorliegen als organische lichtemittierende Vorrichtungen nach Anspruch 1, sowie auch versehen ist mit einer Einrichtung zwecks Zufuhr elektrischer Signale zu den organischen lichtemittierenden Vorrichtungen.

4. Organische Verbindung der allgemeinen Formel (2): 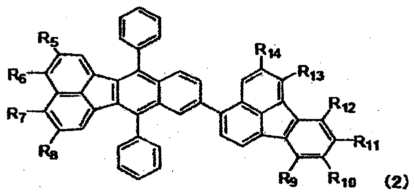 worin R₅ bis R₁₄ unabhängig voneinander bedeuten
- ein Wasserstoffatom,
- eine substituierte oder unsubstituierte Alkylgruppe,
- eine substituierte oder unsubstituierte Aminogruppe,
- eine substituierte oder unsubstituierte Arylgruppe und
- eine substituierte oder unsubstituierte heterocyclische Gruppe.

## Revendications

1. Dispositif électroluminescent organique comportant une cathode, une anode et une couche d'un composé organique disposée entre l'anode et la cathode, **caractérisé en ce que** la couche de composé organique comprend un composé organique représenté par la formule générale (2) : 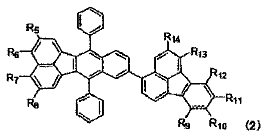 dans laquelle R₅ à R₁₄ représentent indépendamment un atome d'hydrogène, un groupe alkyle substitué ou non substitué, un groupe amino substitué ou non substitué, un groupe aryle substitué ou non substitué et un groupe hétérocyclique substitué ou non substitué.

2. Dispositif électroluminescent organique suivant la revendication 1, dans lequel la couche de composé organique est une couche électroluminescente.

3. Appareil d'affichage d'image qui comporte une pluralité de pixels, les pixels étant les dispositifs électroluminescents organiques suivant la revendication 1, et également un moyen pour transmettre des signaux électriques aux dispositifs électroluminescents organiques.

4. Composé organique représenté par la formule (2) : 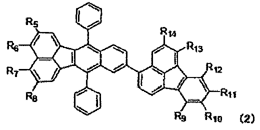 dans laquelle R₅ à R₁₄ représentent indépendamment un atome d'hydrogène, un groupe alkyle substitué ou non substitué, un groupe amino substitué ou non substitué, un groupe aryle substitué ou non substitué et un groupe hétérocyclique substitué ou non substitué.
